# EUROPEAN PATENT APPLICATION

(11) **EP 1 300 444 A1**
(43) Date of publication of application: **09.04.2003**
(21) Application number: 01941250.1
(22) Date of filing: 26.06.2001
(51) Int. Cl.: C08L 63/00, C08L 9/02, C08L 77/06, C08G 59/50

(54) **EPOXY RESIN COMPOSITION AND CURED OBJECT OBTAINED THEREFROM**

(30) Priority: 28.06.2000 JP 2000193792; 20.04.2001 JP 2001122259
(71) Applicant: Nippon Kayaku Kabushiki Kaisha, Tokyo 102-8172 (JP)
(72) Inventor: IMAIZUMI, Masahiro, Kita-ku, Tokyo 115-0052 (JP); ASANO, Toyofumi, Saitama-shi, Saitama 338-0001 (JP); SHINMOTO, Masaki, Saitama-shi, Saitama 338-0013 (JP)
(74) Representative: Gille Hrabal Struck Neidlein Prop Roos
(86) International application number: JP0105451
(87) International publication number: WO02000791

(57) **Abstract**

The present invention is intended to provide cured articles which has excellent heat resistance and excellent flexibility, excellent adhesion, excellent dielectric properties and excellent toughness suitable laminates, metal foil-clad laminates, insulating materials for build-up substrates, flexible printed wiring boards, materials for flexible printed wiring boards, etc.
The epoxy resin compositions of the present invention are characterized by comprising as essential ingredients an epoxy resin (a), an amine curing agent (b), and a phenolic hydroxyl group-containing polyamide-poly(butadiene-acrylonitrile) block copolymer (c).

## Description

### Technical Field

The present invention relates to an epoxy resin composition useful as a resin composition for manufacturing copper-clad laminates used for electronic circuit substrates and as an insulating material for electronic circuit substrates .

### Background Art

A highly information-oriented society where computers and communications apparatus are integrated is developing in recent years. Furthermore, miniaturization, weight saving, and sophistication are progressing in information terminals represented by cellular phones and personal computers which are spreading rapidly. In printed wiring boards mounted on these terminals, densification and thinning are progressing, and accompanied by increase in wiring density and decrease in wiring width, insulating layers buried between circuit conductors require high heat resistance and high reliability to insulation. Moreover, in order to enable mounting of three-dimensionally high density in a narrow space, use of flexible printed wiring boards having flexibility and endurance to repeated bending is expanding.

Epoxy resins are excellent in insulating properties, electrical characteristics, adhesion, and mechanical characteristics of cured articles, and widely used as insulating materials for printed wiring substrates and as materials for flexible printed wiring boards, but encounter the problems of being fragile, cracking by thermal shock, peeling by external impact, and producing easily cracks by bending because of insufficient flexibility. Although these problems have been hitherto settled by adding rubber-like substances to the epoxy resins, addition of the rubber-like substances causes heat resistance to decrease and adhesion to decrease after heating at a high temperature.

The present invention aims at solving these problems and providing an epoxy resin composition which has excellent heat resistance and excellent flexibility and which can be appropriately used for laminates, metal foil-clad laminates, insulating materials for build-up substrates, flexible printed wiring boards, materials for flexible printed wiring boards, etc.

### Disclosure of the Invention

The present inventors have intensively studied to solve the aforesaid problems and accomplished the present invention. That is, the present invention relates to
(1) An epoxy resin composition characterized by comprising as essential ingredients an epoxy resin (a), an amine curing agent (b), and a phenolic hydroxyl group-containing polyamide-poly(butadiene-acrylonitrile) block copolymer (c),
(2) The epoxy resin composition as described above in (1) wherein an ingredient (b) is a guanidine or diaminodiphenyl sulfone,
(3) The epoxy resin composition as described above in (1) or (2) wherein an ingredient (c) is one prepared by use of 3,4'-diaminodiphenyl ether as a starting material,
(4) The epoxy resin composition as described above in any one of (1) to (3) wherein the ingredient (c) is a copolymer represented by the following formula: 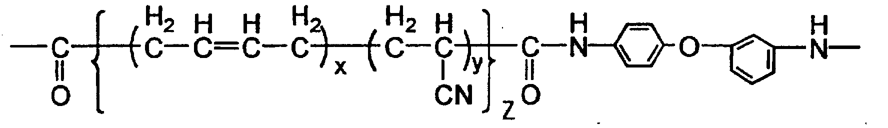 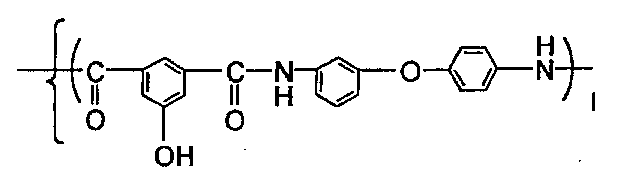 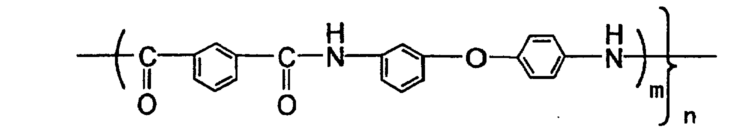 wherein x, y, z, l, m, and n are average polymerization degrees, respectively; x represents an integer from 3 to 10, y represents an integer from one to four, z represents an integer from 5 to 15, 1+m represents an integer from 2 to 200, m/(m+1) ≧ 0.04, and n is from 2 to 100,
(5) An epoxy resin composition characterized by comprising as essential ingredients an epoxy resin (a), a guanidine (b), and a phenolic hydroxyl group-containing polyamide-poly(butadiene-acrylonitrile) block copolymer (c) represented by the following formula: 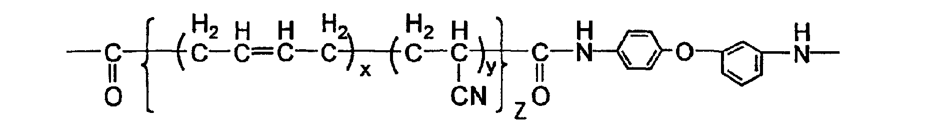 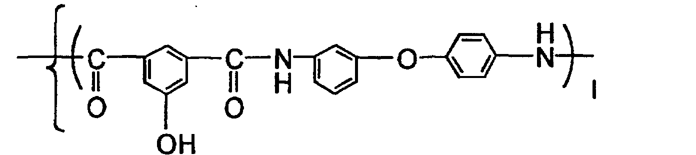 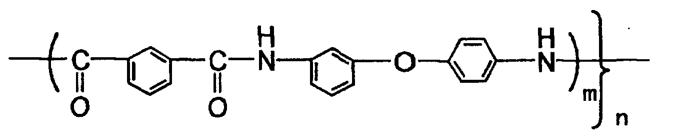 wherein x, y, z, l, m, and n are average polymerization degrees, respectively; x represents an integer from 3 to 10, y represents an integer from 1 to 4, z represents an integer from 5 to 15, 1+m represents an integer from 2 to 200, m/(m+1) ≧ 0.04, and n is from 2 to 100,
(6) An epoxy resin composition characterized by comprising as essential ingredients an epoxy resin (a), diaminodiphenyl sulfone (b), and a phenolic hydroxyl group-containing polyamide-poly(butadiene-acrylonitrile) block copolymer (c) represented by the following formula: 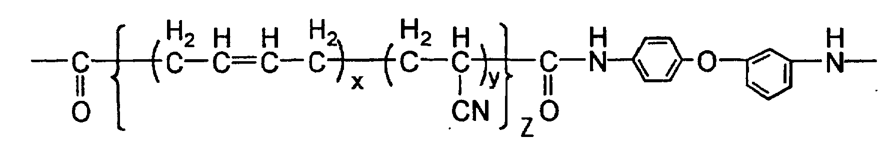 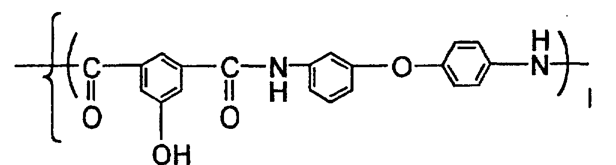 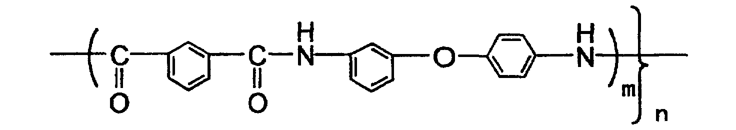 wherein x, y, z, l, m, and n are average polymerization degrees. respectively; x represents an integer from 3 to 10, y represents an integer from one to four, z represents an integer from 5 to 15, l+m represents an integer from 2 to 200, m/(m+1) ≧ 0.04, and n is from 2 to 100,
(7) A varnish prepared by dissolving and/or dispersing in a solvent the epoxy resin composition as described above in any one of (1) to (4),
(8) A varnish prepared by dissolving and/or dispersing in a solvent the epoxy resin composition as described above in (5) or (6),
(9) A flexible printed wiring material where the varnish as described above in (7) is used,
(10) A flexible printed wiring material where the varnish as described above in (8) is used, and
(11) A cured article prepared by curing the epoxy resin composition as described above in any one of (1) to (6).

### Best Mode for Carrying Out the Invention

The present invention is illustrated below in detail.

The epoxy resin (a) used in the present invention includes, for example, (i) glycidyl ether polyfunctional epoxy resins, (ii) glycidyl ester epoxy resins, (iii) glycidyl amine epoxy resins, (iv) alicyclic epoxy resins, and (v) heterocyclic epoxy resins, etc., but are not limited to these. In the present invention the polyfunctional epoxy resins mean epoxy resins having two or more glycidyl groups.

The glycidyl ether polyfunctional epoxy resins (i) include, for example, (ia) polyfunctional epoxy resins that are glycidyl etherified products of polyphenol compounds, (ib) polyfunctional epoxy resins that are glycidyl etherified products of various novolak resins, and (ic) aliphatic epoxy resins that are glycidyl etherified products of polyhydric alcohols, etc.

Polyphenol compounds used as starting materials of the polyfunctional epoxy resins of (ia) include polyphenol compounds such as substituted or unsubstituted bisphenols, for example, unsubstituted bisphenols or bisphenols having lower (C1 to C4) alkyl substituents on benzene ring or/and having halogeno substituents such as fluorine on the alkyl chains, such as bisphenol A, bisphenol F, bisphenol S, tetramethylbisphenol A, dimethylbisphenol A, tetramethyl-bisphenol F, dimethyl- bisphenol F, tetramethylbisphenol S and dimethylbisphenol S, etc. 4,4'-biphenylphenol, tetramethyl-4,4'-biphenol, dimethyl-4,4'-biphenylphenol, 1-(4-hydroxyphenyl)-2-[4-(1,1-bis-(4-hydroxyphenyl)ethyl)phenyl]propane, 2,2'-methylene-bis(4-methyl-6-tert-butyl-phenol) and 4,4'-butylidene-bis(3- methyl-6-tert-butyl-phenol), trishydroxyphenylmethane, resorcinol, hydroquinone, pyrogallol, and phenols having a diisopropylidene skeleton, phenols having a fluorene skeleton such as 1,1-di-4-hydroxyphenylfluorene, polybutadiene allowed to react with phenols, etc. These polyphenol compounds are allowed to react with glycidyl ethers, thereby to prepare the glycidyl ether polyfunctional epoxy resins used in the present invention.

The polyfunctional epoxy resins of (ib) include glycidyl etherified products of various novolak resins. For example, it includes glycidyl etherified products of various novolak resins such as novolak resins prepared as starting materials from various phenols such as substituted or unsubstituted mono-or polyphenols and substituted or unsubstituted mono- or polynaphthols, phenolnovolak resins containing a xylylene skeleton, phenolnovolak resins containing a dicyclopentadiene skeleton, phenolnovolak resins containing a biphenyl skeleton, phenolnovolak resins containing a fluorene skeleton, phenolnovolak resins containing a phenanthrene skeleton or phenolnovolak resins containing a furan skeleton. The substituted or unsubstituted mono- or polyphenols and the substituted or unsubstituted mono- or polynaphthols used as the starting materials of the above novolak resins include, for example, mono- or polyphenols and mono- or polynaphthols that have one to 3 hydroxy groups. These can have substituents other than the hydroxy group. The substituents other than the hydroxy group include, for example, unsubstituted alkyl groups having 1 to 10 carbon atoms, substituted alkyl groups having 1 to 10 carbon atoms, halogen atoms, etc., and the substituted alkyl groups having 1 to 10 carbon atoms include alkyl groups having 1 to 10 carbon atoms which are substituted, for example, by halogen atoms, phenyl group, hydroxy-substituted phenyl groups, etc. The alkyl groups having 1 to 10 carbon atoms include methyl group, ethyl group, propyl group, butyl group, pentyl group, hexyl group, heptyl group, octyl group, nonyl group, decanyl group, etc.

Typical examples of the mono- or polyphenols and the mono-or polynaphthols include cresols, ethylphenols, butylphenols, octylphenols, bisphenol A, bisphenol F, bisphenol S, naphthols, etc.

The aliphatic epoxy resins of (ic) include, for example, glycidyl etherified products of the following polyhydric alcohols. The polyhydric alcohols used as the starting materials of the aliphatic epoxy resins include, for example, 1,4-butanediol, 1,6-hexanediol, polyethylene glycol, pentaerythritol, etc.

The glycidyl ester epoxy resins of the aforesaid (ii) include epoxy resins comprising glycidyl esters of carboxylic acids, preferably dicarboxylic acids. For example, the resins include epoxy resins comprising diglycidyl esters of dicarboxylic acids such as hexahydrophthalic acid or phthalic acid, etc.

The glycidyl amine epoxy resins of the aforesaid (iii) include, for example, epoxy resins where a glycidyl group is introduced into amines, preferably, aromatic amines. For example, the resins include epoxy resins where a glycidyl group is introduced into phenylamines such as aniline or toluidine, etc.

The alicyclic epoxy resins of the aforesaid (iv) include, for example, epoxy resins having C4-C8 cyclorings, preferably C5-C6 cyclorings. For example, the resins include alicyclic epoxy resins having an aliphatic skeleton such as cyclohexane, etc.

The heterocyclic epoxy resins of the aforesaid (v) include, for example, five and six-membered heterocyclic epoxy resins. Specifically, the resins include, for example, heterocyclic epoxy resins having heterocycles such as isocyanuric ring or hydantoin ring, etc.

Of these epoxy resins, epoxy resins used can be appropriately selected depending upon characteristics demanded. The glycidyl ether epoxy resins are preferred in general. The preferable glycidyl ether epoxy resins are novolak type epoxy resins having a phenol skeleton, novolak type epoxy resins having a triphenylmethane skeleton, and novolak type epoxy resins having a dicyclopentadiene skeleton. The novolak type epoxy resins having a phenol skeleton include, for example, bisphenol type epoxy resins (bisphenol A type epoxy resins, bisphenol F type epoxy resins, etc.), phenol novolak type epoxy resins, cresol novolak type epoxy resins, novolak type epoxy resins having a phenol skeleton and a naphthol skeleton, novolak type epoxy resins having a phenol skeleton and a biphenyl skeleton, and phosphate atoms-containing novolak resins having a phosphaphenanthrene skeleton, etc.

Examples of the amine curing agents (b) used in the present invention include aromatic amines such as diaminodiphenylmethane. diaminodiphenyl sulfone, diamino-diphenyl ether, p-phenylenediamine, m-phenylenediamine, o-phenylenediamine, 1,5-diaminonaphthalene or m-xylylenediamine, aliphatic amines such as ethylenediamine, diethylenediamine, isophorone-diamine, bis(4-amino-3-methyl-dicyclohexyl)methane or polyether diamine, and guanidines such as dicyandiamide or 1-(o-tolyl)biguanide. Although the amine curing agents used can be appropriately selected depending upon characteristics demanded, guanidines and diaminodiphenyl sulfone are preferred.

These amine curing agents (b) are used generally in a range of from 0.3 to 2.0, preferably from 0.4 to 1.6, and further preferably from 0.5 to 1.3 in equivalent ratio of the curing agent to the epoxy group in epoxy resins (a). The aforesaid curing agents also can be used as mixtures of two or more thereof.

In the present invention, the phenolic hydroxyl group-containing polyamide-poly(butadiene-acrylonitrile) block copolymers (c) are used. The preferred phenolic hydroxyl group-containing polyamides parts in the block copolymers include, for example, those represented by the following formula

-NH-R-NH-{(CO-R₁-CO-NH-R-NH)₁-(CO-R₂-CO-NH-R-NH)ₘ}ₙ-

wherein R represents a divalent residual group of an aliphatic hydrocarbon with 1 to 10 carbon atoms which may have substituents or a divalent residual group where the aforesaid plural, preferably two or three divalent residual groups are linked to one another through crosslinking groups such as -O-, -S-, -SO₂-, and -NH-, or a divalent residual group of an aromatic hydrocarbon of 6 to 10 carbon atoms which may have substituents or a divalent aromatic hydrocarbon residual group where the aforesaid plural, preferably two or three aromatic hydrocarbon residual groups are linked to one another through crosslinking groups such as a straight or branched chain alkylene of one to four carbon atoms which may have substituents, -O-, -S-, -SO₂-, and -NH-; R₁ represents a residual group of a dicarboxylic acid of 6 to 12 carbon atoms which has at least one phenolic hydroxyl group, for example, a hydroxyl-substituted phenylene group; and R₂ represents a residual group of dicarboxylic acid of 6 to 12 carbon atoms which has no phenolic hydroxyl group, for example, a phenylene group. Further, l, m, and n are average polymerization degrees, respectively. l+m represents -an integer from 2 to 200, m/(m+1) ≧ 0.04, and n is from 2 to 100, preferably from 2 to 30.) Although the ratio of m to 1 is not particularly limited as long as m/(m+1) ≧ 0.04, the value in general is preferably 0.5 or below.

The block copolymers (c) are necessary for imparting toughness, adhesion, and flexibility to the cured articles, and the addition thereof can impart excellent toughness without deterioration in heat resistance of the cured articles.

The amount of the phenolic hydroxyl group-containing polyamides-poly(butadiene-acrylonitrile) block copolymers (c) used is preferably 2 mass % or above to the entire epoxy resin contained in the epoxy resin composition. The amount in general is from 10 to 100 mass %, and more preferably from 20 to 80 mass %.

The ingredient (c) can be synthesized by condensing a dicarboxylic acid ingredient including a phenolic hydroxyl group-containing dicarboxylic acid (in some cases a phenolic hydroxyl group-containing dicarboxylic acid itself) with a diamine ingredient according to ordinary methods as described in United States patents. For example, the diamine is added in an excess amount to a dicarboxylic acid ingredient consisting of a phenolic hydroxyl group-containing dicarboxylic acid such as 5-hydroxyisophthalic acid and a dicarboxylic acid containing no phenolic hydroxyl group such as isophthalic acid, and heated with stirring in the presence of a condensing agent (e.g., phosphite esters) and a pyridine derivative in an organic solvent such as N-methyl-2-pyrrolidone in an inactive atmosphere such as nitrogen to carry out condensation reaction, preparing a phenolic hydroxyl group-containing polyamide oligomer. To the resulting solution of a phenolic hydroxyl group-containing polyamide oligomer that has amino groups in both terminals, a poly(butadiene-acrylonitrile) copolymer that has carboxyl groups in both terminals is added to carry out polycondensation, thereby acquiring the block copolymer.

Although the ratio of the poly(butadiene-acrylonitrile) copolymer to the polyamide oligomer is not particularly limited, the poly(butadiene-acrylonitrile)copolymer in general is from about 0.1 to about 10 parts to one part of the polyamide oligomer.

An excess of the dicarboxylic acid is used to the diamine to synthesize a polyamide having carboxyl groups in both terminals and to this, a poly(butadiene-acrylonitrile) copolymer having amino groups in both terminals can be used for blocking. Furthermore, it also is possible to modify the terminals of the polyamide or the poly(butadiene-acrylonitrile) copolymer to react. In this case, one terminal can be modified by a vinyl group and the other terminal by -NH group or -SH group. In the step of synthesizing the ingredient (c), a compound containing a phenolic hydroxyl group in part or all of the diamine can be used.

The phenolic hydroxyl group-containing dicarboxylic acids composing the dicarboxylic acid ingredient used for the ingredient (c) include, for example, 5-hydroxyisophthalic acid, 4-hydroxyisophthalic acid, 2-hydroxyphthalic acid, 3-hydroxyphthalic acid or 2-hydroxyterephthalic acid, etc. and the dicarboxylic acids containing no phenolic hydroxyl group include phthalic acid, isophthalic acid, terephthalic acid, dicarboxylnaphthalene, succinic acid, fumaric acid, glutaric acid, adipic acid, 1,3-cyclohexanedicarboxylic acid, 4,4'-diphenyldicarboxylic acid or and 3,3'-methylene-di(benzoic acid), etc.

The diamine ingredient includes, as phenolic hydroxyl group-containing diamines, 3,3'-diamine-4,4'-dihydroxyphenylmethane, 2,2-bis(3-amino-4-hydroxyphenyl)-hexafluoropropane, 2,2-bis(3-amino-4-hydroxyphenyl)- difluoromethane, 3,4-diamino-1,5-benzenediol, 3,3'-dihydroxy-4,4'-diaminobisphenol, 3,3'-diamino-4,4'-dihydroxybiphenyl, 2,2-bis(3-amino-4-hydroxyphenyl)ketone, 2,2-bis(3-amino-4-hydroxyphenyl) sulfide, 2,2-bis(3-amino-4-hydroxyphenyl) ether, 2,2-bis(3-amino-4-hydroxyphenyl) sulfone, 2,2-bis(3-amino-4-hydroxyphenyl)propane, 2,2-bis(3-hydroxy-4-aminophenyl)propane, 2,2-bis(3-hydroxy-4-aminophenyl)methane, etc. and as the diamine containing no phenolic hydroxyl group, 3,3'-diaminodiphenyl ether, 3,4'-diaminodiphenyl ether, 4,4'-diaminodiphenyl ether, diaminonaphthalene, piperazine, hexanethylenediamine, tetramethylenediamine, m-xylenediamine, 4,4'-diaminodiphenylmethane, 4,4'-diaminobenzophenone, 2,2'-bis(4-aminophenyl)propane, 3,3'-diaminodiphenyl sulfone, 3,3'-diaminodiphenyl, etc. Although 3,4'-diaminodiphenyl ether is preferred, the diamine ingredient is not limited to these in the present invention.

Poly(butadiene-acrylonitrile) copolymers having various functional groups in both terminals are marketed by Goodrich Corp. as Hycar CTBN (trade name), and can be used together with the aforesaid phenolic hydroxyl group-containing polyamide oligomers for blocking.

Of the phenolic hydroxyl group-containing polyamide-poly(butadiene-acrylonitrile) copolymers (c) thus prepared, copolymers represented by the following formula 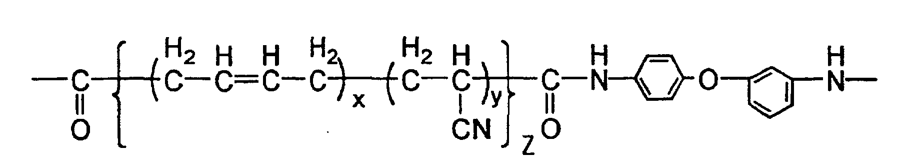 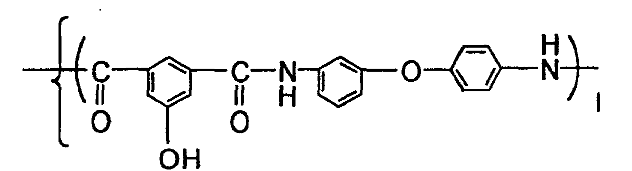 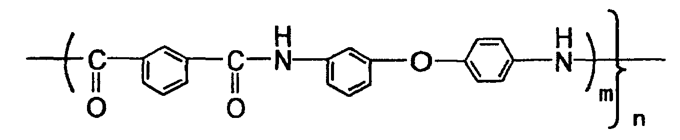 wherein x, y, z, l, m, and n are average polymerization degrees, respectively, x represents an integer from 3 to 10, y represents an integer from 1 to 4, z represents an integer from 5 to 15, and 1+m represents an integer from 2 to 200, m/(m+1) ≧ 0.04, and n is from 2 to 100,
are particularly preferred.

Curing accelerators can be added as needed to the epoxy resin composition of the present invention. The curing accelerators are not particularly limited, and examples thereof include various imidazoles such as 2-methylimidazole, 2-ethyl-4-methylimidazole, 2-phenylimidazole, 2-undecylimidazole, 2-heptadecylimidazole, 2-phenyl-4-methylimidazole, 1-benzyl-2-phenylimidazole, 1-benzyl-2-methylimidazole, 1-cyanoethyl-2-methylimidazole, 1-cyanoethyl-2-phenylimidazole, 1-cyanoethyl-2-undecylimidazole, 2,4-diamino-6(2'-methylimidazole(1'))ethyl-s-triazine, 2,4-diamino-6(2'-undecylimidazole(1'))ethyl-s-triazine, 2,4-diamino-6(2'-ethyl-4-methylimidazole(1'))ethyl-s-triazine, 2,4-diamino-6(2'-methylimidazole(1'))ethyl-s-triazine isocyanuric acid adduct, a 2:3 adduct of 2-methylimidazole isocyanuric acid, a 2-phenylimidazole isocyanuric acid adduct, 2-phenyl-3,5-dihydroxymethyl- imidazole, 2-phenyl-4-methyl-5-hydroxymethylimidazole or 1-cyanoethyl-2-phenyl-3, 5-dicyanoethoxymethylimidazole; imidazoles as salts of those imidazoles and polycarboxylic acids such as phthalic acid, isophthalic acid, terephthalic acid, trimellitic acid, pyromellitic acid, naphthalenedicarboxylic acid, maleic acid or oxalic acid; phosphorus compounds such as triphenylphosphine; tertiary amine compounds such as triethylamine, tetraethanolamine, 1,8-diaza-bicyclo[5.4.0]-7-undecene(DBU), N,N-dimethylbenzylamine, 1,1,3,3-tetramethylguanidine or N-methylpiperazine; and boron compounds such as 1,8-diaza-bicyclo[5.4.0]-7-undecenium tetraphenylborate. The curing accelerators are used as needed generally in a ratio of from 0.01 to 5 mass parts, preferably from 0.1 to 3 mass parts relative to 100 mass parts of the epoxy resins.

Other additives can be added as needed to the epoxy resin composition of the invention. The ratios of the other additives are not particularly limited as long as the epoxy resin composition of the invention can be cured. The other additives in general can be used as needed in a ratio of from 0 to about 500 mass parts to 100 mass parts of the epoxy resin.

Examples of the other additives include plasticizers such as natural waxes, synthetic waxes or metal salts of long chain fatty acids; release agents such as acid amides, esters or paraffin; stress relaxation agents such as nitrile rubber or butadiene rubber; inorganic flame retardants such as tin oxide, tin hydroxide, molybdenum oxide, zinc borate, barium metaborate, aluminum hydroxide, magnesium hydroxide or calcium aluminate; organic flame retardants such as trimethyl phosphate, triethyl phosphate, triphenyl phosphate, tricresyl phosphate, trixylylenyl phosphate, cresyldiphenyl phosphate, cresyl-2,6-dixylylenyl phosphate, 1,3-phenylene-bis(diphenyl phosphate), 1,3-phenylenebis-(dixylylenyl phosphate), 1,4-phenylene-bis(dixylylenyl phosphate), 4,4'-biphenyl(dixylylenyl phosphate), 9,10-dihydro-9-oxa-10-phosphaphenanthrene-10-oxide or 10(2,5-dihydroxyphenyl)-10H-9-oxa-10- phosphaphenanthrene-10-oxide; coupling agents such as silane coupling agents, titanate coupling agents or aluminum coupling agents; inorganic fillers or conductive particles such as fused silica, crystalline silica, low α-radiation silica, glass flake, glass bead, glass balloon, talc, alumina, calcium silicate, aluminum hydroxide, calcium carbonate, barium sulfate, magnesia, silicon nitride, boron nitride, metal powders such as ferrite, rare-earth cobalt, gold, silver, nickel, copper, lead, iron powder, iron oxide or iron sand, graphite, carbon or chrome yellow; ion-capturing agents such as BiO_{X}(OH)_{Y}(NO₃)_{Z} wherein X is from 0.9 to 1.1, Y is from 0.6 to 0.8, and Z is from 0.2 to 0.4, Mg_{X}Al_{Y}(OH)_{2X+3Y-2Z}CO_{Z}·mH₂O wherein X, Y, and Z are positive numbers satisfying 2X+3Y-2Z ≧ 0 and m is a positive number, Sb₂O₅·2H₂O, SbSi_{V}Bi_{W}O_{X}(OH)_{Y}(NO₃)_{Z}·nH₂O wherein V is a positive number from 0.1 to 0.3, W is that from 1.5 to 1.9, X is that from 4.1 to 4.5, Y is that from 1.2 to 1.6, Z is that from 0.2 to 0.3, and n is an integer one or two or zirconium phosphate; colorants such as dyes or pigments; inorganic fiber such as carbon fiber, glass fiber, boron fiber, silicon carbide fiber, alumina fiber or silica alumina fiber; organic fiber such as aramid fiber, polyester fiber, cellulose fiber or carbon fiber; antioxidants, light stabilizers, humidity resistance improvers, thixotropic agents, diluents, anti-foaming agents, various other resins, tackifiers, antistatic agents, lubricants, ultraviolet absorbers, etc. and these other additives may be mixed.

The epoxy resin compositions of the present invention can be prepared by mixing uniformly the epoxy resin (a), the amine curing agent (b), the phenolic hydroxyl group-containing polyamide-poly(butadiene-acrylonitrile)block copolymer (c), as needed the curing accelerator, and other additives.

In order to obtain a cured article of the epoxy resin composition of the present invention, the resin composition is appropriately applied depending upon the objective, and cured, for example, by a conventional method such as thermosetting depending upon the curing agent and/or the curing accelerator used.

When the epoxy resin composition of the present invention is used, for example, as amaterial composing build-up substrates or flexible printed wiring substrates, a varnish is prepared from the epoxy resin composition of the present invention, applied, for example, by a coating method etc. depending upon the objective, thereafter removed of the solvent as needed, and cured by a method such as thermal curing. When the varnish is prepared, the epoxy resin (a), the amine curing agent (b), the phenolic hydroxyl group-containing polyamidepoly(butadiene-acrylonitrile) block copolymer (c), as needed the curing accelerator, and other additives than a solvent for varnish are mixed uniformly in the solvent.

When the varnish is prepared, the amount of the solvent in general is not particularly limited as long as the amount makes it possible to coat the varnish. It is preferred to use the solvent so that the solid content in general becomes about 40 to about 80 percent.

Examples of the solvent include organic solvents such as toluene, ethanol, cellosolve, tetrahydrofuran, N-methyl-2-pyrrolidone or dimethylformamide.

The varnish thus obtained can be appropriately used as a material for insulating sheets for build-up substrates and insulating material-attached metal foils for build-up substrates and an adhesive for forming flexible printed wiring substrates, cover lay materials, and bonding sheets (hereinafter, these are collectively named materials for flexible printed wiring boards).

The insulating sheets for build-up substrates and the insulating material-attached metal foil for build-up substrates for which the varnish of the present invention is used are illustrated below.

In a process for preparing the insulating sheets for build-up substrates, in the case of the insulating sheet having a release film layer on one side, the varnish prepared beforehand (the varnish of the present invention, and so forth) is coated onto a release film by use of a roll coater, a comma coater, etc. This is allowed to pass through an in-line dryer, heated in general at 40 to 160°C for 2 to 20 minutes to remove the solvent in the varnish, forming an adhesive layer. In the case of an insulating sheet having release film layers on both sides, a release film is pressed and bonded on the adhesive-coated surface of the insulating sheet with the adhesive prepared according to the aforesaid process by heated rollers to prepare the insulating sheet. The thickness of the coated adhesive in general may be from 40 to 80 µm in a dry condition.

The release films usable here include polyethylene film, polypropylene film, TPX (methylpentene copolymer) film, PE (polyethylene) film, polyethylene film with a silicone release agent, polypropylene film and PE film, polyethylene resin-coated paper, polypropylene resin-coated paper, TPX resin-coated paper, etc. About the thickness of the release films, that of film-based films is preferably from 13 to 75 µm and that of paper-based films is preferably from 50 to 200 µm, but the thickness is not particularly limited and can be appropriately determined as needed.

In a process for preparing the insulating material-attached metal foils for build-up substrates where the varnish of the present invention is used, the varnish prepared beforehand is coated onto the metal foil by use of a roll coater, a comma coater, etc. This is allowed to pass through an in-line dryer generally at 40 to 160°C for 2 to 20 minutes to remove the solvent in the varnish, forming an insulating layer. The thickness of the insulating layer coated may be generally from 40 to 80 µm in a dry condition.

The metal foil usable here is exemplified by electrolytic copper foil, rolled copper foil, aluminum foil, tungsten foil, iron foil, etc., and the electrolytic copper foil and the rolled copper foil in general are used in view of processability, bending properties, electrical conductivity, etc. Although the thickness of the metal foil in general is from 3 to 70 µm, it is not particularly limited and appropriately determined depending upon the conditions of application, etc.

Multilayer printed wiring boards can be obtained by use of the insulating sheet for build-up substrates and the insulating-attached metal foil for build-up substrates thus prepared. Specifically, circuit processing is first carried out on an insulating substrate to form a first circuit, and an insulating layer is formed on the first circuit by applying pressure and heat to the insulating sheet for build-up substrates and/or the insulating material-attached metal foil for build-up substrates by means of a laminator, a press, etc. In order to improve the adhesion between the first circuit and the insulating layer, oxidation-reduction treatment of copper constructing the first circuit or primer treatment by a dilute resin solution before applying pressure and heat to improve impregnating properties can be carried out. Subsequently, jointing holes reaching the first circuit are formed on the insulating layer by laser processing and furthermore through holes are formed as needed by a drill or a laser, and thereafter the second circuit is formed on the insulating layer. When the insulating layer is formed by the insulating sheet for build-up substrates, in order to improve adhesion to electroless plating copper, areas to form the second circuit or the jointing holes are selectively chemically roughened with an acidic oxidizing etching solution such as chrome-sulfuric acid or with an alkaline oxidizing etching solution such as metallic salts of permanganate as a pretreatment, then neutralized, washed with water, added catalyst and, thereafter through these processes, immersed in a plating solution of electroless copper to allow copper to precipitate on the through holes, the non-penetrating jointing holes and the insulating layer until reaching a necessary thickness. Electrolytic plating can be carried out if necessary to increase the thickness . Thereafter, a wiring pattern for the second circuit is formed through etching to prepare a multilayer printed wiring board. Furthermore, it also is possible that areas other than the areas to form the second circuit are masked with plating resist, the areas to form the circuit and the jointing holes are selectively chemically roughened with the aforesaid etching solution to improve adhesion to electroless plating copper, neutralized, washed with water, added catalysts and, after these processes, immersed in a plating solution of electroless copper to allow copper to precipitate on the through holes, the non-penetrating jointing holes and the insulating layer until reaching a necessary thickness to form a wiring pattern, and thereby to prepare a multilayer printed wiring board.

When the insulating layer is constructed by using the insulating material-attached metal foil for build-up substrates , in order to improve adhesion between the insulating layer and the electroless plating copper, the jointing holes are selectively chemically roughened with the etching solution as described above, neutralized, washed with water, added catalyst and, thereafter through these processes, immersed in the plating solution of elecroless copper to allow copper to precipitate on the through holes and the non-penetrating jointing holes until reaching a desired thickness. Then, if necessary, the electrolytic plating can be carried out to increase thickness. Subsequently, the wiring pattern for the second circuit is formed through etching or laser processing to prepare a multilayer printed wiring board. A multilayer printed wiring board having further more layers can be made by repeating the aforesaid processes looking upon the second circuit as the first circuit.

The varnish of the present invention is cured by applying pressure and heat in the above description. However, for example, cold cure caused by a catalyst, oxygen, and moisture at about room temperature, and photo-setting caused by catalysis of acid generated by ultraviolet radiation can be simultaneously used.

Materials for the flexible printed wiring boards where the varnish of the present invention is used are illustrated below.
The constitution of the flexible wiring substrates is a three-layer structure consisting of electrical film/adhesive/metal foil. Although the thickness of the adhesive in general is from 10 to 20 µm, it can be appropriately determined depending upon the conditions of application, etc. The leading form of cover lay materials is film-based cover lay coated with an adhesive on one side of a base film. The constitution of the film-based cover lay is a three-layer structure consisting of electrical insulative film/adhesive/release film. Although the thickness of the adhesive in general is from 15 to 50 µm, it can be appropriately determined depending upon the conditions of application, etc. Furthermore, the form of cover lay includes dry film type cover lay, liquid type cover lay, etc. The dry film type one is of a three-layer structure consisting of release film/adhesive/release film and the adhesive layer doubles as an insulating layer. Although the thickness of the adhesive in general is from 25 to 100 µm, it can be determined depending upon the conditions of application, etc. In the liquid type one, the insulating layer is made by coating and curing. The constitution of the bonding sheet is a three-layer structure consisting of release film/adhesive/release film. Although the thickness of the adhesive in general is from 15 to 50 µm, it can be appropriately determined depending upon the conditions of application, etc.

Examples of the aforesaid electrical insulative film usable include polyimide film, PET (polyethyleneterephthalate) film, polyester film, poly(parabanic acid) film, poly(ether ether ketone) film, polyphenylene sulfide film, aramid film, etc. Of these, polyimide film is preferred in view of heat resistance, dimensional stability, mechanical characteristics, etc. Although the thickness of the films in general ranges from 12.5 to 75 µm, it is not particularly limited and appropriately determined as needed. Furthermore, one side or both sides of these films can be subjected to surface treatment such as low-temperature plasma treatment, corona discharge treatment, sandblast treatment.

The aforesaid metal foil includes metal foil similar to that usable for the aforesaid metal foil with insulating materials for build-up substrates, and the aforesaid release film includes a release film similar to that usable for the aforesaid insulating sheets for build-up substrates, respectively.

In a process for preparing the film-based cover lay, the varnish of the present invention prepared beforehand is coated onto the aforesaid electrical film by use of a roll coater, comma coater, etc. This is allowed to pass through an in-line dryer and heated at 40 to 160°C from 2 to 20 minutes to remove the solvent in the varnish, forming an adhesive layer. Subsequently, A release film is pressed and bonded on the adhesive-coated surface of the electrical insulative film with the adhesive by heat rollers. The thickness of the adhesive coated is generally from 15 to 50 µm in a dry condition.

In a process for preparing the dry film type cover lay, the varnish prepared beforehand is coated onto a release film by use of a roll coater, comma coater, etc. This is allowed to pass through an in-line dryer and heated at 40 to 160°C for 2 to 20 minutes to remove the solvent in the varnish, forming an adhesive layer. A release film is pressed and bonded on the adhesive-coated surface of the release film with the adhesive by heat rollers. The thickness of the adhesive coated is generally from 25 to 100 µm in a dry condition.

For preparation of the liquid type cover lay, the viscosity of the varnish is adjusted by adding a solvent so as to become suitable for the coating procedure.

In a process for preparing the bonding sheet, the varnish prepared beforehand is coated onto a release film by use of arollcoater, commacoater, etc. This is allowed to pass through an in-line dryer and heated at 40 to 160°C for 2 to 20 minutes to remove the solvent in the varnish, forming an adhesive layer. A release film is pressed and bonded on the adhesive-coated surface of the release film with the adhesive by heat rollers. The thickness of the adhesive coated may be generally from 15 to 50 µm in a dry condition.

In a process for preparing the flexible printed wiring substrates of the present invention, the varnish prepared beforehand is coated onto the aforesaid electrical insulative film by use of a roll coater, a comma coater, etc. This is allowed to pass through an in-line dryer and heated at 40 to 160°C for 2 to 20 minutes to remove the solvent in the varnish, forming an adhesive layer. A release film is pressed and bonded on the adhesive-coated surface of the electrical insulative film with the adhesive by heat rollers. The thickness of the adhesive coated may be generally from 10 to 20 µm in a dry condition.

### Examples

The present invention is further illustrated more specifically through examples, but is not to be construed as limited by these. In the examples and comparative examples, percent and parts are based on mass unless otherwise noted.

### Synthesis Example 1

### Synthesis of Polyamide A (phenolic hydroxyl group-containing aromatic polyamide-poly(butadiene-acrylo nitrile) block copolymer)

In a 1-liter four-neck round-bottom flask, 19.93 g (120 mmol) of isophthalic acid, 30.63 g (153 mmol) of 3,4'-diaminodiphenyl ether, 3.64 g (20 mmol) of 5-hydroxyisophthalic acid, 3.9 g of lithium chloride, 12.1 g of calcium chloride, 240 ml of N-methyl-2-pyrrolidone, and 54 ml of pyridine were placed and stirred to be dissolved, and subsequently 74 g of triphenyl phosphite was added thereto and allowed to react at 90°C for four hours to prepare a phenolic hydroxyl group-containing aromatic polyamide oligomer. To this, a solution where 48 g of a poly(buadiene-acrylonitrile) copolymer having carboxyl groups at both terminals (Hycar CTBN, manufactured by BF Goodrich Corp, the acrylonitrile ingredient contained in the poly (butadiene-acrylonitrile) parts:17 mole percent, the molecular weight: about 3600.) were dissolved in 240 ml of N-methyl-2-pyrrolidone was added, allowed to react further for four hours, and cooled to room temperature. The resulting reaction solution was poured into 20 liters of methanol to precipitate an aromatic polyamide-poly(butadiene acrylo nitrile) block copolymer where the content of poly(butadiene- acrylonitrile) copolymer parts was 50 percent and the phenolic hydroxyl group contained was about 14 mole percent (ingredient (C) of the present invention; hereinafter referred to as polyamide A). This precipitated polymer was further washed with methanol and refluxed in methanol to be purified. The intrinsic viscosity of this polymer was 0.85 dl/g (dimethylacetamide, 30°C). The IR spectrum of the polymer powder was measured by the diffused reflection method, and absorption based on an amidocarbonyl group was observed at 1674 cm⁻¹, absorption based on the C-H bonds of the butadiene parts was observed at 2856 to 2975 cm⁻¹, and absorption based on the nitrile group was observed at 2245 cm⁻¹, respectively.

### Example 1

The epoxy resin composition (unit: "part") shown in the column of Example 1 of Table 1 was dissolved in a mixed solvent consisting of one part of N,N-dimethylformamide (DMF) and one part of methyl isobutyl ketone (MEK) to prepare a varnish where the concentration of the solid content was 60 percent. The varnish was inpregnated in glass cloth of 180 µm in thickness and 50 mm × 50 mm in size (Trade name WEA18W105F115N, Manufactured by Nitto Boseki Co., Ltd.) and the solvent was removed under drying conditions of 130°C × 5 minutes and 150°C × 2 minutes to obtain a prepreg.

### Examples 2 to 4 and Comparative Examples 1 and 2

Prepregs were prepared similarly to Example 1 except that the epoxy resin compositions shown in the respective columns of Examples 2 to 3 and Comparative Examples 1 of Table 1 were used.

### Test Examples

Three sheets of the respective prepregs obtained in Examples 1 to 4 and Comparative Examples 1 and 2 and two sheets of copper foil of 35 µm in thickness and 50 mm × 50 mm in size were used. The three sheets of the respective prepregs obtained in the Examples and the Comparative Examples were put between the two sheets of the copper foil, and heated and pressurized under conditions of 130°C × 20 minutes and 175°C × 60 minutes, and 30 kg/cm² to prepare a copper-clad laminate of three layers. The resulting copper-clad laminate was subjected to the following tests, that is, heat resistance, bending test, strength for peeling off copper foil, and solder heat resistance. Results are shown in Table 2.

(Heat Resistance) The glass transition temperatures (Tg) of the copper-clad laminates prepared in the examples and comparative examples were measured by the TMA method at a condition of rising temperature of 2 °C/minute.

(Bending Test) The copper-clad laminates were bent till 180° and evaluated by the generation of cracks at bent portions .

(Strength for Peeling off Copper Foil) Measurement was carried out by use of the copper-clad laminates according to JIS C 6481 5.7.

(Solder Heat Resistance) Test specimens of 25 mm × 25 mm in size were cut off from the copper-clad laminates and floated in a solder bath of 260°C for five minutes, and the generation of swelling or peeling was observed. Evaluation was carried out as follows. o: Swelling or peeling was not observed. ×: Swelling or peeling was observed. Results are shown in Table 2.

(Dielectric Constant) The varnishes prepared in the examples and the comparative examples were squeezed to polyethylene terephthalate (PET) films so that the dried films have a thickness of 50 µm and cured at 170°C for one hour, and the PET films were peeled off to prepare samples. Measurement was carried out according to ASTM D150.

**Table 1**

| | Example | | | | Comparative Example | |
|---|---|---|---|---|---|---|
| | 1 | 2 | 3 | 4 | 1 | 2 |
| Epoxy Resin A | 50 | | | 50 | 50 | 50 |
| Epoxy Resin B | | 100 | | | | |
| Epoxy Resin C | | | 100 | | | |
| Epoxy Resin D | 50 | | | 50 | 50 | 50 |
| Curing agent A | 9.9 | | 3.5 | | 9.9 | |
| Curing agent B | | 7.5 | | | | |
| Curing agent C | | | | 37 | | |
| Curing agent D | | | | | | 58 |
| accelerator A | 1 | 1 | 1 | 1 | 1 | 1 |
| Polyamide A | 30 | 30 | 30 | 30 | | 30 |

### In Table 1:

Epoxy Resin A: EPPN-502H (Novolak type epoxy resin having a triphenylmethane skeleton; Manufactured by Nippon Kayaku Co., Ltd.; Epoxy equivalent: 168 g/eq)

Epoxy Resin B: NC-7300L (Novolak type epoxy resin having a phenol skeleton and a naphthol skeleton; Manufactured by Nippon Kayaku Co., Ltd.; Epoxy equivalent: 220 g/eq)

Epoxy Resin C: FX-277BEK75 (Novolak type epoxy resin having a 9,10-dihydro-9-oxa-10-phosphaphenanthrene-10-oxide skeleton; Manufactured by Toto Kasei K.K.; Epoxy equivalent: 299 g/eq; MEK 25% cut product)

Epoxy Resin D: RE-404S (Bisphenol F type epoxy resin; Manufactured by Nippon Kayaku Co., Ltd.; Epoxy equivalent: 165 g/eq)

Curing agent A: DICY7 (Dicyandiamide; Manufactured by Japan Epoxy Resin K.K.)

Curing agent B: DX147 (Guanidine compound; Manufactured by Japan Epoxy Resin K.K.)

Curing agent C: Diaminodiphenyl sulfone (Manufactured by Wakayama Seika Kogyo; Amine equivalent; 62 g/eq)

Curing agent D: Kayahard TPM (Novolak resin having a triphenylmethane skeleton; Manufactured by Nippon Kayaku Co., Ltd.; Hydroxyl equivalent: 97 g/eq)

Accelerator A: 2-Phenyl-4-methyl-5-hydroxymethylimidazole

**Table 2**

| | Example | | | | Comparative Example | |
|---|---|---|---|---|---|---|
| | 1 | 2 | 3 | 4 | 1 | 2 |
| Tg (°C) | 170 | 135 | 165 | 175 | 171 | 170 |
| Bending Test (Generation of Cracks) | none | none | none | none | observed | none |
| Strength for Peeling off (N/cm) | 19 | 20 | 19 | 20 | 16 | 19 |
| Solder Heat Resistance | o | o | o | o | o | o |
| Dielectric Constant (1 MHz) | 3.9 | 3.9 | 3.9 | 3.9 | 3.8 | 4.2 |

### Industrial Applicability

The cured articles of the epoxy resin compositions of the present invention are excellent in heat resistance, flexibility, adhesion, dielectric properties, and toughness and very useful for laminates, metal foil-clad laminates, insulating materials for build-up substrates, flexible printed wiring boards, materials for flexible printed wiring boards, etc.

## Claims

1. An epoxy resin composition **characterized by** comprising as essential ingredients an epoxy resin (a), an amine curing agent (b), and a phenolic hydroxyl group-containing polyamide-poly(butadiene-acrylonitrile) block copolymer (c).

2. The epoxy resin composition as described in claim 1 wherein an ingredient (b) is a guanidine or diaminodiphenyl sulfone.

3. The epoxy resin composition as described in claims 1 or 2 wherein an ingredient (c) is one obtained by use of 3,4'-diaminodiphenyl ether as a starting material.

4. The epoxy resin composition as described in any one of claims 1 to 3 wherein the ingredient (c) is a copolymer represented by the following formula: 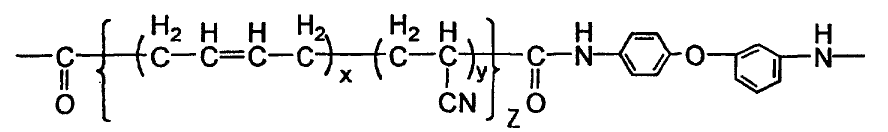 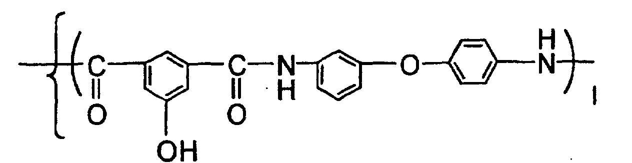 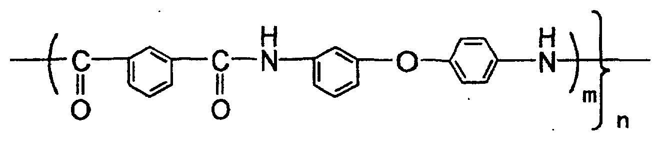 (in the formula x, y, z, l, m, and n are average polymerization degrees, respectively; x represents an integer from 3 to 10, y represents an integer from 1 to 4, z represents an integer from 5 to 15, and 1+m represents an integer from 2 to 200, m/(m+1) ≥ 0.04, and n is from 2 to 100).

5. An epoxy resin composition **characterized by** comprising as essential ingredients an epoxy resins (a), a guanidine (b), and a phenolic hydroxyl group-containing polyamide-poly(butadiene-acrylonitrile) block copolymer (c) represented by the following formula: 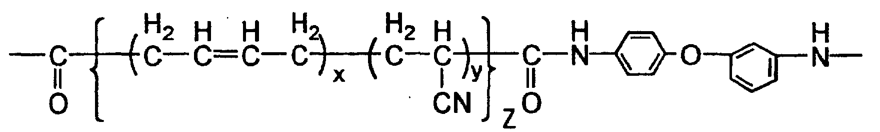 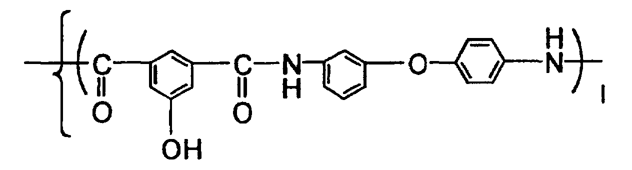 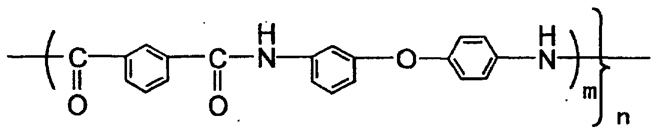 (in the formula x, y, z, l, m, and n are average polymerization degrees, respectively; x represents an integer from 3 to 10, y represents an integer from one to four, z represents an integer from 5 to 15, 1+m represents an integer from 2 to 200, m/(m+1) ≥ 0.04, and n is from 2 to 100).

6. An epoxy resin composition **characterized by** comprising as essential ingredients an epoxy resin (a), diaminodiphenyl sulfone (b), and a phenolic hydroxyl group-containing polyamide-poly(butadiene-acrylonitrile) block copolymer (c) represented by the following formula: 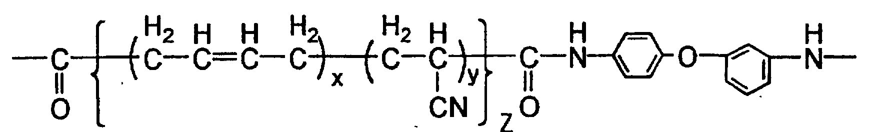 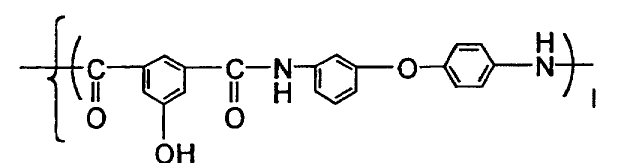 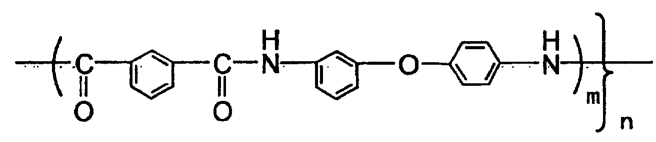 wherein x, y, z, l, m, and n are average polymerization degrees, respectively; x represents an integer from 3 to 10, y represents an integer from one to four, z represents an integer from 5 to 15, 1+m represents an integer from 2 to 200, m/(m+1) ≥ 0.04, and n is from 2 to 100.

7. A varnish prepared by dissolving and/or dispersing in a solvent the epoxy resin composition as described in any one of claims 1 to 4.

8. A varnish prepared by dissolving and/or dispersing in a solvent the epoxy resin composition as described in claims 5 or 6.

9. A flexible printed wiring material where the varnish as described in claim 7 is used.

10. A flexible printed wiring material where the varnish as described in claim 8 is used.

11. Cured articles prepared by curing the epoxy resin compositions as described in claims 1 to 6.
